# EUROPEAN PATENT APPLICATION

(11) **EP 4 723 497 A1**
(43) Date of publication of application: **08.04.2026**
(21) Application number: 24306627.1
(22) Date of filing: 04.10.2024
(51) Int. Cl.: H04B 5/43

(54) **AN ANTENNA ARRANGEMENT**

(71) Applicant: NXP B.V., 5656 AG Eindhoven (NL)
(72) Inventor: MERLIN,, Erich, 5656 AG Eindhoven (NL); KURVATHODIL,, Manoj, 5656 AG Eindhoven (NL); MAURICE,, Eric, 31023 Toulouse cedex 1 (FR); MOREAU,, Olivier Claude, 31023 Toulouse cedex 1 (FR)
(74) Representative: Krott, Michel

(57) **Abstract**

An antenna arrangement comprising: a first antenna; a second antenna; a first transmitter path having: the first antenna located its second end; and a first matching circuit arranged between a first end of the first transmitter path and the first antenna; a second transmitter path having: the second antenna located its second end; and a second matching circuit arranged between a first end of the second transmitter path and the second antenna; a first receiver path coupled to the first transmitter path at a first tapping point arranged between the first end of the first transmitter path and the first antenna; a second receiver path coupled to the second transmitter path at a second tapping point arranged between the first end of the second transmitter path and the second antenna; and a balun arranged to electrically isolate the first antenna from the second antenna.

## Description

### Field

The present disclosure relates to an antenna arrangement and an NFC device. In particular, the present disclosure relates to an antenna arrangement comprising first and second antennas each configured to receive and transmit near field communication signals and an NFC device comprising such an antenna arrangement.

### Summary

According to a first aspect of the present disclosure, there is provided an antenna arrangement comprising: a first antenna configured to receive and transmit a first set of near field communication signals; a second antenna configured to receive and transmit a second set of near field communication signals; a first transmitter path comprising a first end and a second end, wherein the first antenna is located at the second end of the first transmitter path and wherein the first transmitter path comprises a first matching circuit arranged between the first end of the first transmitter path and the first antenna; a second transmitter path comprising a first end and a second end, wherein the second antenna is located at the second end of the second transmitter path and wherein the second transmitter path comprises a second matching circuit arranged between the first end of the second transmitter path and the second antenna; a first receiver path coupled to the first transmitter path at a first tapping point wherein the first tapping point is arranged between the first end of the first transmitter path and the first antenna; a second receiver path coupled to the second transmitter path at a second tapping point wherein the second tapping point is arranged between the first end of the second transmitter path and the second antenna; and a balun arranged to electrically isolate the first antenna from the second antenna.

In one or more embodiments, the antenna arrangement may further comprise: a first EMC filter arranged between the first end of the first transmitter path and the first antenna; and a second EMC filter arranged between the first end of the second transmitter path and the second antenna, wherein the first EMC filter comprises a first filter capacitor having a first terminal coupled to the first tapping point; the second EMC filter comprises a second filter capacitor having a first terminal coupled to the output node of the second tapping point; and wherein the antenna arrangement further comprises a reference voltage node coupled between the capacitors of the first filter capacitor and second filter capacitor.

In one or more embodiments, the balun may be arranged between the first EMC filter and a first antenna leg wherein the first antenna leg comprises the first matching circuit and the first antenna; and wherein the balun is further arranged between the second EMC filter and a second antenna leg, wherein the second antenna leg comprises the second matching circuit and the second antenna.

In one or more embodiments, the balun may comprise: a first winding arranged between the first EMC filter and the first antenna leg; and a second winding arranged between the second EMC filter and the second antenna leg

In one or more embodiments, the first antenna may comprise a first node coupled to an output node of the first matching circuit and a second node coupled to a reference voltage node; and the second antenna may comprise a first node coupled to the second matching circuit and a second node coupled the reference voltage node.

In one or more embodiments, the first matching circuit may comprise: a first capacitor arranged in series between the balun and the first antenna; and a first grounding capacitor arranged in parallel with the first antenna between the first transmitter path and a reference voltage node; and the second matching circuit may comprise: a second capacitor arranged in series between the balun and the second antenna; and a second grounding capacitor arranged in parallel with the second antenna between the second transmitter path and the reference voltage node.

In one or more embodiments, the balun may be arranged between the first matching circuit and the first antenna and wherein the balun may be further arranged between the second matching circuit and the second antenna.

In one or more embodiments, the balun may comprise: a first winding arranged between the first matching circuit and the first antenna; and a second winding arranged between the second matching circuit and the second antenna.

In one or more embodiments, the first matching circuit may further comprise a first grounding capacitor arranged between the first transmitter path and a reference voltage node; and the second matching circuit may further comprise a second grounding capacitor arranged between the second transmitter path and the reference voltage node.

In one or more embodiments, an intermediate matching capacitor may be arranged between the first matching circuit and the second matching circuit.

In one or more embodiments, the antenna arrangement may further comprise: a signal sensor configured to measure a signal at the first antenna and provide signalling indicative of the measured signal; and a controller configured to receive the signalling indicative of the measured signal and determine which antenna has been triggered based on the signalling.

In one or more embodiments, the balun may be arranged with an additive polarity.

In one or more embodiments, the balun may be arranged with a subtractive polarity.

According to a second aspect of the present disclosure, there is provided a Near Field Communications, NFC, device comprising the antenna arrangement of the first aspect.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of an antenna arrangement of the present disclosure;
Figure 2 shows an alternative example embodiment of an antenna arrangement of the present disclosure;
Figure 3 shows yet another example embodiment of an antenna arrangement of the present disclosure;
Figure 4 shows a further example embodiment of an antenna arrangement of the present disclosure;
Figure 5 shows a yet further example embodiment of an antenna arrangement of the present disclosure; and
Figure 6 shows an example Near Field Communications, NFC, device comprising the antenna arrangement of any preceding claim.

### Detailed Description

The present disclosure relates to an antenna arrangement for a Near-Field Communications device (NFC device). NFC is a short-range wireless technology that allows NFC-enabled devices to communicate with each other. Such devices may include mobile phones, tablets, laptops, wearables and other devices. NFC technology can be used for contactless payments, data sharing, mobile ticketing and access control, among other uses.

Given the wide range of applications that NFC is being put to in modern society, it is becoming increasingly desirable for an NFC-enabled device to be able to perform multiple functionalities sequentially or simultaneously. Practically, this requires the implementation of multiple antennas which are each configured to receive and transmit NFC signals. The present disclosure provides front-end topologies with antennas connected with corresponding topologies to a common reference voltage node (such as a ground node). The topologies of the present disclosure may provide for improved phase and amplitude balance management.

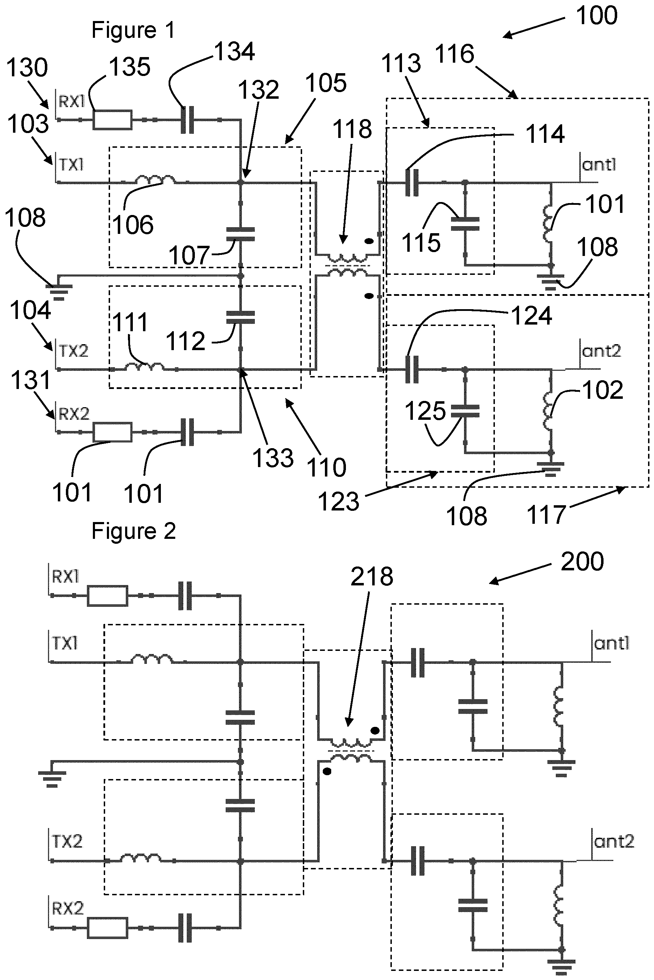

Figure 1 shows an example antenna arrangement 100 according to the present disclosure. The antenna arrangement 100 comprises first and second antennas 101, 102 and the supporting electronics that support the receipt and transmission of near field communication (NFC) signals.

The antenna arrangement 100 comprises a first antenna 101 which is configured to receive and transmit a first set of near field communication signals. The first antenna 101 is represented in figure 1 by inductor 101. The configuration of the first antenna 101 to receive and transmit the near field communication signals includes properties such as its size, conductivity and other electrical or physical properties which allow it to operate as an antenna at a desired frequency or frequencies. For example, a typical operating frequency for NFC may be approximately 13.56 MHz, however, this is not the only frequency which may be selected.

The antenna arrangement 100 further comprises a second antenna 102 which is configured to receive and transmit a second set of near field communication signals. The second antenna 102 is represented in figure 1 by inductor 102. The configuration of the second antenna 102 to provide for the receipt and transmission of NFC signals may include the configuration of the size, conductivity and other electrical or physical properties which allow it to operate as an antenna at a desired frequency or frequencies.

The antenna arrangement 100 further comprises a first transmitter path 103 and a second transmitter path 104. The transmitter paths 103, 104 comprise electronics which may couple their respective antenna 101, 102 to a transmitter device (not shown) where the transmitter device is configured to generate signals for transmission or may be configured to be coupled to a transmitter device configured to generate signals for transmission. That is, it will be appreciated that the antenna arrangement 100 does not necessarily need to be coupled to a transmitter device (or, as will be discussed later, a receiver device) in order to provide all of the features that are core to the present disclosure, as defined in the claims. As a result of this, the transmitter device and the receiver device which could provide for the transmission of signals, or which may process the received signals, respectively, will not be discussed in detail herein. In general, the transmitter device and receiver device may be implemented as an NFC integrated circuit which is configured to generate outgoing signals and process incoming signals. It will be appreciated that alternative implementations may also be used.

The first transmitter path 103 may comprise a first EMC filter 105. The first EMC filter 105 may provide for attenuation of undesirable electromagnetic interference, such as harmonics of the signal for transmission. That is, the first EMC filter 105 may improve the robustness of the antenna arrangement 100 to internally generated or external electromagnetic signals at frequencies which the first EMC filter 105 is configured to attenuate. The first EMC filter 105 may, therefore, allow the antenna arrangement 100 to operate reliably. In other embodiments, the first EMC filter may not be present. The first EMC filter 105 may be located at any point along the first transmitter path. When included, the first EMC filter 105 may be preferably located at the first end of the transmitter path 103.

The first EMC filter 105 may comprise a first EMC filter inductor 106 arranged in series between a first end of the first transmitter path 103, where the first end of the first transmitter path 103 may be configured to receive a transmission signal for transmission by the first antenna 101. That is, a first node of the first EMC filter inductor 106 may be coupled to a first node (first end) of the first transmitter path 103. A second node of the first EMC filter inductor 106 may be coupled to a first node of a first matching circuit or a balun, described below. The second node of the first EMC filter inductor 106 may further be coupled to a first node of a first EMC filter capacitor 107. The first EMC filter capacitor 107 may be coupled to a reference voltage node 108, such as a ground node. More specifically, a second node of the first EMC filter capacitor 107 may be coupled to a reference voltage node 108, such as a ground node.

Similarly, the second transmitter path 104 may comprise a second EMC filter 110. The second EMC filter 110 may provide for attenuation of undesirable electromagnetic interference, such as harmonics of the signal for transmission. That is, the second EMC filter 110 may improve the robustness of the antenna arrangement 100 to internally generated or external electromagnetic signals at frequencies which the second EMC filter 110 is configured to attenuate. The second EMC filter 110 may, therefore, allow the antenna arrangement 100 to operate reliably. In other embodiments, the second EMC filter may not be present. The second EMC filter 110 may be located at any point along the second transmitter path. The second EMC filter 110 may be located at any point along the first transmitter path. When included, the first EMC filter 105 may be preferably located at the first end of the transmitter path 103.

The second EMC filter 110 may comprise a second EMC filter inductor 111 arranged in series between a first end of the second transmitter path 104, where the first end of the second transmitter path 104 may be configured to receive a transmission signal for transmission by the second antenna 102. That is, a first node of the second EMC filter inductor 111 may be coupled to a first node of the second transmitter path 104. The second node of the second EMC filter inductor 111 may further be coupled to a first node of a second EMC filter capacitor 112. The second EMC filter capacitor 112 may be coupled to a reference voltage node 108, such as a ground node, which may be the reference voltage node to which the first EMC filter capacitor 107 is coupled. More specifically, a second node of the second EMC filter capacitor 112 may be coupled to a reference voltage node 108, such as a ground node. That is, the first and second EMC filter capacitors 107, 112 may be arranged in series between the first transmitter path 103 and the second transmitter path 104 and the first and second EMC filter capacitors 107, 112 may further comprise an intermediate reference voltage node 108 therebetween.

Any reference voltage node referred to herein may comprise a ground node set to a relative 0 volts or may refer to a node which is configured, in use, to be coupled to a ground node set to a relative 0 volts. This reference voltage nodes referred to herein may be reference voltage nodes which are couplable to ground. Any reference node may be set to a same relative voltage as one or more of the other reference nodes, or one or more reference nodes may be set to different reference voltages, as is appropriate to enable operation of the antenna arrangement in the described manner. It will further be appreciated that, typically, reference nodes, such as a ground node, are only considered coupled to ground when the arrangement is coupled to a power source. As such, references to nodes or terminals being couplable to ground are understood by the skilled person as being a clear reference that such an amplifier circuit does not need to be coupled to a power source to be an amplifier circuit according to the present disclosure but is configured to be so coupled in use.

The antenna arrangement 100 further comprises a balun 118 arranged to electrically isolate the first antenna and the second antenna. In particular, the antenna arrangement may comprise a balun 118 having a first winding and a second winding. The first winding may be arranged such that it is in series along the first transmitter path 103. The second winding may be arranged such that it is in series along the second transmitter path 104. By arranging the first winding and the second winding in series along the first and second transmitter paths, electrical isolation of the first antenna and the second antenna are achieved. The balun 118 may be arranged at several different points through the transmitter paths relative to the matching circuits described below. The balun 118 may be arranged in an additive polarity, as depicted in figure 1. In other embodiments, such as in an embodiment depicted in figure 2, the balun 218 may be arranged to have a subtractive polarity. The polarity of the balun may be selected in order to compensate any phase or amplitude imbalance caused by the antennas' connections with respect to a position of a reference voltage node (such as a ground node) in the device into which the antenna arrangement is installed (such as the position of a ground node within a phone).

The first transmitter path 103 further comprises a first matching circuit 113. The first matching circuit 113, which may be a first impedance matching circuit, may be configured to provide for one or both of compensation for the inductive impedance of the first antenna 101; and to implement an impedance transformation from a load impedance to a source impedance.

The first matching circuit 113 may comprise a first capacitor 114 arranged in series between the balun 118 and the first antenna 101. In particular, the first capacitor 114 may be arranged in series between the first winding of the balun 118 and the first antenna 101.

The second transmitter path 104 further comprises a second matching circuit 123. The second matching circuit 123, which may be a second impedance matching circuit, may be configured to provide for one or both of compensation for the inductive impedance of the second antenna 101; and to implement an impedance transformation from a load impedance to a source impedance.

The second matching circuit 123 may comprise a second capacitor 124 arranged in series with the second EMC filter 110 and the second antenna 102. In particular, the second capacitor 124 may be arranged in series between the second EMC filter 104 and the second antenna 102.

A plurality of different implementations may be used for the structure of the matching circuits 113, 123, as depicted in figures 1-5. In the example depicted in figure 1 and figure 2, the first and second matching circuits 113, 123 may be arranged between the balun 118, 218 and the first and second antenna 101, 102, respectively. In particular, a first node of a first winding of the balun 118, 218 may be coupled to an output node of the first EMC filter 105. The output node of the first EMC filter 105 may be the second node of the first EMC filter inductor. Similarly, a first node of a second winding of the balun 118, 218 may be coupled to an output node of the second EMC filter 110. The output node of the second EMC filter 110 may be the second node of the second EMC filter inductor 111, for example. A second node of the first winding of the balun 218 118 may be coupled to an input node of the first matching circuit 113. The input node of the first matching circuit 113 may be, for example, a first node of the first capacitor 114 of the first matching circuit 113. Similarly, a second node of the second winding of the balun 118, 218 may be coupled to an input node of the second matching circuit 123. The input node of the second matching circuit 123 may be, for example, a second node of the second capacitor 124 of the second matching circuit 123.

Where the balun 118 is arranged between the EMC filter circuits 105, 110 and the matching circuits 113, 123, the section of the first transmitter path after the balun 118 may be referred to as a first antenna leg 116 and the section of the second transmitter path after the balun 118 may be referred to as a second antenna leg 117.

The first matching circuit 113 may further comprise a first grounding capacitor 115 wherein the first grounding capacitor 115 is arranged in parallel with the first antenna 101 between the first transmitter path 103 and a reference voltage node 108. In particular, a first node of the first grounding capacitor 115 may be coupled to a second node of the first capacitor 114 and a second node of the first grounding capacitor 115 may be coupled to a reference voltage node 108, such as a ground node.

The second matching circuit 123 may further comprise a second grounding capacitor 125 wherein the second grounding capacitor 125 is arranged in parallel with the second antenna 102 between the second transmitter path 104 and a reference voltage node 108. In particular, a first node of the second grounding capacitor 125 may be coupled to a second node of the second capacitor 124 and a second node of the second grounding capacitor 125 may be coupled to a reference voltage node 108, such as a ground node.

The order of first EMC filter 105, the first matching circuit 113 and the balun 118 may be different in different embodiments. For example, in the embodiment depicted in figure 1, the first EMC filter 105 is arranged towards the first end of the transmitter path, followed by the balun 118, followed by the first matching circuit 113. In other embodiments, the order may be, for example: first EMC filter 105 - first matching circuit 113 - balun 118. The embodiments represented in figures 1-5 may provide for one or more preferred embodiments. The same flexibility in the order of the second EMC filter, balun and the second matching circuit is also possible.

The antenna arrangement 100 further comprises first and second receiver paths 130, 131 which are coupled to their respective transmitter paths 103, 104 at a first tapping point 132 and a second tapping point 133, respectively. While the whole length of conductor between the first end of the first transmitter path (TX1) and the first antenna 101 is referred to herein as the first transmitter path 103, it will be appreciated that this is done for ease of reference. It will be understood that received signals will still travel at least the part of the "first transmitter path 103" (as referred to herein) between the first antenna 101 and the first tapping point 132. Indeed, the received signals may also travel through other parts of the antenna arrangement 100, however, the signals of interest for the receiver path 130 are those which will travel from the first antenna 101 to the first tapping point 132 and from the first tapping point 132 to the first end of the receiver path 130 which may be coupled or couplable to a receiver device (not shown). The same description may be equally applied to the path travelled by signals received at the second antenna 102 which travel along at least part of the second transmitter path 104.

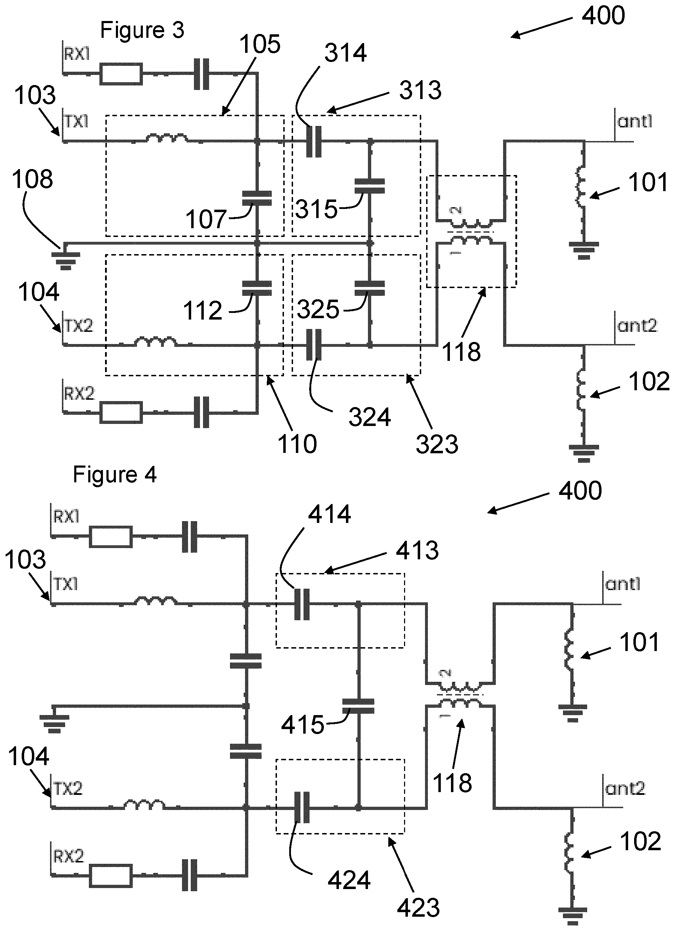

The first receiver path 130 may comprise a first receiver path capacitor 134 and a first receiver path resistor 135 wherein the first receiver path capacitor 134 and the first receiver path resistor 135 are coupled in series between a first end (first node) of the first receiver path 130 and the first tapping point 132. The first tapping point 132 is arranged to couple to the first transmitter path 103 at a point between the first end of the first transmitter path and the first antenna 101. In one or more embodiments, the first tapping point 132 may be arranged to couple to an output node of the first EMC filter 105. In one or more embodiments, such as those described with reference to figures 1 and 2, the first tapping point 132 may also be directly coupled to a first node of the first winding of the balun 118. In one or more alternative embodiments, such as those depicted in figures 3 and 4, the first tapping point 133 may also be directly coupled to the first capacitor 314, 414 of the first matching circuit 313, 413. In general, the first tapping point 132 may be located anywhere along the first transmitter path 103. This flexibility of position is achieved due to the use of a balun 118. Similarly, the second tapping point 133 is arranged to couple the second transmitter path 104 at a point between the first end of the second transmitter path 104 and the second antenna 102. In one or more embodiments, the second tapping point 133 may be arranged to couple to an output node of the second EMC filter 110. In one or more embodiments, such as those described with reference to figures 1 and 2, the second tapping point 133 may also be directly coupled to a first node of the second winding of the balun 118. In one or more alternative embodiments, such as those depicted in figures 3 and 4, the second tapping point 133 may also be directly coupled to the second capacitor 324, 424 of the second matching circuit 323, 423. In general, the second tapping point 133 may be located anywhere along the second transmitter path. This flexibility of position is achieved due to the use of a balun, as disclosed herein.

The topologies described herein may provide for the maintenance of a phase difference of approximately 180° between a first receiver path and a second receiver path. Providing the tapping points at a point along their respective transmitter paths, in transmitter paths comprising a common balun provides a balancing effect which allows these phase differences to be maintained with or without detuning due to the presence of a card near an antenna.

As described above, figure 2 shows an example antenna arrangement 200 comprising a balun 218 arranged to have subtractive polarity. The remainder of the components depicted in figure 2 are the same as those depicted in figure 1 and so these will not be redescribed here.

Figures 3 and 4 show alternative example embodiments of antenna arrangements 300, 400 in which the balun 118 is arranged along the first and second transmitter paths 103, 104 between the matching circuits 313, 323, 413, 423 and the antennas 101, 102. More specifically, the first winding of the balun 118 is arranged between the first matching circuit 313, 413 and the first antenna 101. That is, a first node of the first winding of the balun 118 is coupled to an output node (such as the second node of the first capacitor) of the first matching circuit 313 and a second node of the first winding of the balun 118 is coupled to a first node of the first antenna 101. Similarly, the second winding of the balun 118 is arranged between the second matching circuit 323, 423 and the second antenna 102. That is, a first node of the second winding of the balun 118 is coupled to an output node (such as the second node of the second capacitor) of the second matching circuit 323, 423 and a second node of the second winding of the balun 118 is coupled to a first node of the second antenna 102. The winding of the balun 118 in these embodiments are depicted in the figures as being arranged with a positive polarity, however, it will be appreciated that a negative polarity may also be used.

Where the representation of figures is unchanged or substantially unchanged between figure 1 and figures 3 and 4, the same reference numerals have been used.

In some embodiments, such as the embodiment depicted in figure 3, the first matching circuit 313 further comprise a first grounding capacitor 315 wherein the first grounding capacitor 315 is arranged in parallel with the first EMC filter capacitor 107 between the first transmitter path 103 and a reference voltage node 108. In particular, a first node of the first grounding capacitor 315 may be coupled to a second node of the first capacitor 314 and a second node of the first grounding capacitor 315 may be coupled to a reference voltage node 108, such as a ground node.

The second matching circuit 323 may further comprise a second grounding capacitor 325 wherein the second grounding capacitor 325 is arranged in parallel with the second EMC filter capacitor 112 between the second transmitter path 104 and a reference voltage node 108. In particular, a first node of the second grounding capacitor 325 may be coupled to a second node of the second capacitor 324 and a second node of the second grounding capacitor 325 may be coupled to a reference voltage node 108, such as a ground node.

In some embodiments, such as the embodiment depicted in figure 4, the first and second matching circuits 413, 423 may be coupled by an intermediate matching capacitor 415 which is arranged between the first transmitter path 103 and the second transmitter path 104. In particular, the intermediate matching capacitor 415 may comprise a first node coupled to the first transmitter path 103 and a second node coupled to the second transmitter path 104. In some embodiments, the intermediate matching capacitor 415 may comprise a first node coupled to a second node of the first capacitor 414 of the first matching circuit 413 and the intermediate matching capacitor 415 may further comprise a second node coupled to a second node of the second matching capacitor 424 of the second matching circuit 423.

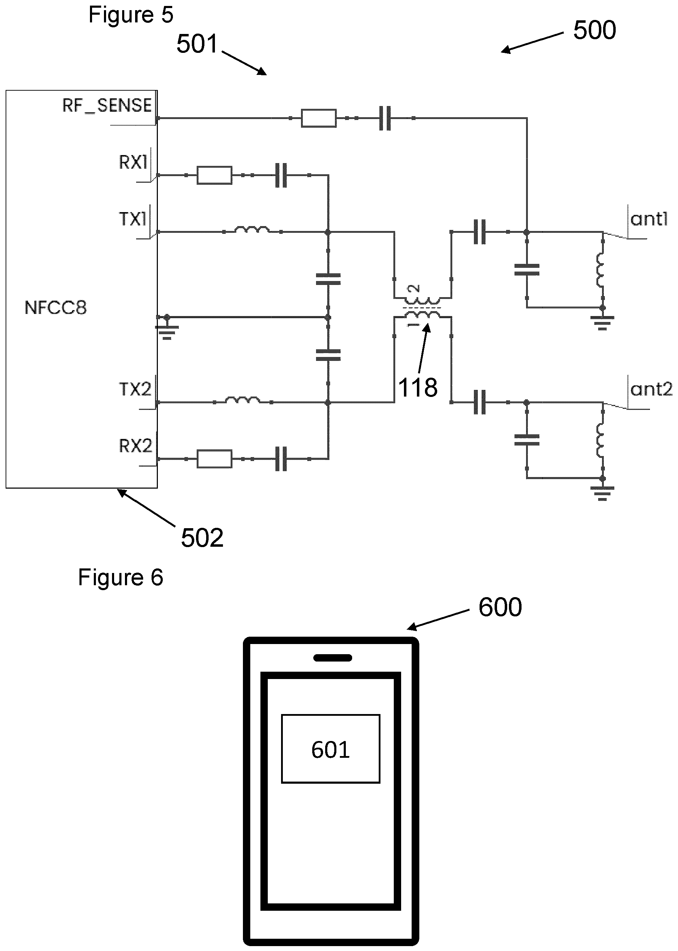

Figure 5 shows an example antenna arrangement 500 according to the present disclosure and described with reference to figures 1-2. The antenna arrangement 500 depicted in figure 5 further comprises a signal sensor 501 configured to measure a signal at the first antenna 101. The signal sensor 501 may be any suitable signal sensor 501 configured to measure an electrical signal, such as a voltage, over the first antenna 101. In one or more embodiments, the signal sensor 501 may comprise a connection of a first node of the first antenna 101 to an analogue input of an integrated circuit 502 and wherein the integrated circuit 502 is configured to measure the signal at the first antenna 101. The signal sensor 501 may be configured to provide signalling to an integrated circuit 502 indicative of the signal at the first antenna 101. Based on the signalling, the integrated circuit 502 may be configured to determine the voltage at the first antenna and, thereby, determine which of the antennas 101, 102 is currently in operation. Being able to determine the signal, such as a voltage, over one of the two antennas 101, 102 may be particularly beneficial because, under normal operation, it may not be possible to determine which of the antennas 101, 102 is receiving a signal (has been triggered by placement). By providing for a signal measurement at one of the antennas 101, it is possible to distinguish which of the antennas 101, 102 has been activated. While the antenna arrangement 500 is depicted with the balun 118 arranged between the EMC filter circuits and the matching circuits, it will be appreciated that the voltage sensor 501 may also be implemented in embodiments wherein the balun is arranged between the matching circuits and the antennas, as depicted in figures 3 and 4, or at any other point along the transmitter path.

In one or more embodiments, the signal sensor 501 may be a voltage sensor 501 configured to measure a voltage over the first antenna 101. The voltage sensor 501 may be configured to provide signalling to the integrated circuit 502 indicative of a voltage at the first antenna 101. Based on the signalling, the integrated circuit 502 may be configured to determine which of the antennas 101, 102 is currently in operation. It will be appreciated that the signal sensor may be a different type of signal sensor, such as a current sensor or another sensor which measures an electrical property over the first antenna.

Figure 6 shows an example Near Field Communication (NFC) device 600 comprising the antenna arrangement 601, such as the antenna arrangements 100, 200, 300, 400, 500 of figures 1-5. The NFC device 600 may be any device in which it may be desirable to have two antennas. For example, the NFC device 600 may be a mobile phone, a tablet device, a smart watch, a payment terminal, an access control system, smart-jewellery, wireless earbuds or headphones, a gaming console, a medical device or a type of apparel.

It will be appreciated by a person skilled in the art that configuring the various components of the antenna arrangement to operate within certain frequency/time/impedance regimes may involve scaling the magnitudes of said components to suitable sizes, inductances, capacitances, resistances and other electrical characteristics to operate within the desired regime. It will be appreciated by a skilled person that just because components of another circuit may be connected in similar arrangements, if they are configured for operation of different technical uses, then they may not necessarily provide for the same technical effect as the circuits disclosed herein.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An antenna arrangement comprising:
a first antenna configured to receive and transmit a first set of near field communication signals;
a second antenna configured to receive and transmit a second set of near field communication signals;
a first transmitter path comprising a first end and a second end, wherein the first antenna is located at the second end of the first transmitter path and wherein the first transmitter path comprises a first matching circuit arranged between the first end of the first transmitter path and the first antenna;
a second transmitter path comprising a first end and a second end, wherein the second antenna is located at the second end of the second transmitter path and wherein the second transmitter path comprises a second matching circuit arranged between the first end of the second transmitter path and the second antenna;
a first receiver path coupled to the first transmitter path at a first tapping point wherein the first tapping point is arranged between the first end of the first transmitter path and the first antenna;
a second receiver path coupled to the second transmitter path at a second tapping point wherein the second tapping point is arranged between the first end of the second transmitter path and the second antenna; and
a balun arranged to electrically isolate the first antenna from the second antenna.

2. The antenna arrangement of any preceding claim wherein further comprising:
a first EMC filter arranged between the first end of the first transmitter path and the first antenna; and
a second EMC filter arranged between the first end of the second transmitter path and the second antenna, wherein
the first EMC filter comprises a first filter capacitor having a first terminal coupled to the first tapping point;
the second EMC filter comprises a second filter capacitor having a first terminal coupled to the output node of the second tapping point; and
wherein the antenna arrangement further comprises a reference voltage node coupled between the capacitors of the first filter capacitor and second filter capacitor.

3. The antenna arrangement of claim 2 wherein the balun is arranged between the first EMC filter and a first antenna leg wherein the first antenna leg comprises the first matching circuit and the first antenna; and wherein the balun is further arranged between the second EMC filter and a second antenna leg, wherein the second antenna leg comprises the second matching circuit and the second antenna.

4. The antenna arrangement of claim 3 wherein the balun comprises: a first winding arranged between the first EMC filter and the first antenna leg; and a second winding arranged between the second EMC filter and the second antenna leg

5. The antenna arrangement of claim 3 or claim 4 wherein:
the first antenna comprises a first node coupled to an output node of the first matching circuit and a second node coupled to a reference voltage node; and
the second antenna comprises a first node coupled to the second matching circuit and a second node coupled the reference voltage node.

6. The antenna arrangement of any of claims 3-5 wherein:
the first matching circuit comprises:
a first capacitor arranged in series between the balun and the first antenna; and
a first grounding capacitor arranged in parallel with the first antenna between the first transmitter path and a reference voltage node; and
the second matching circuit comprises:
a second capacitor arranged in series between the balun and the second antenna; and
a second grounding capacitor arranged in parallel with the second antenna between the second transmitter path and the reference voltage node.

7. The antenna arrangement of claim 1 wherein the balun is arranged between the first matching circuit and the first antenna and wherein the balun is further arranged between the second matching circuit and the second antenna.

8. The antenna arrangement of claim 7 wherein the balun comprises: a first winding arranged between the first matching circuit and the first antenna; and a second winding arranged between the second matching circuit and the second antenna.

9. The antenna arrangement of claim 7 or claim 8 wherein:
the first matching circuit further comprises a first grounding capacitor arranged between the first transmitter path and a reference voltage node; and
the second matching circuit further comprises a second grounding capacitor arranged between the second transmitter path and the reference voltage node.

10. The antenna arrangement of claim 7 or claim 8 wherein an intermediate matching capacitor is arranged between the first matching circuit and the second matching circuit.

11. The antenna arrangement of any preceding claim further comprising:
a signal sensor configured to measure a signal at the first antenna and provide signalling indicative of the measured signal; and
a controller configured to receive the signalling indicative of the measured signal and determine which antenna has been triggered based on the signalling.

12. The antenna arrangement of any preceding claim wherein the balun is arranged with an additive polarity.

13. The antenna arrangement of any of claims 1-12 wherein the balun is arranged with a subtractive polarity.

14. A Near Field Communications, NFC, device comprising the antenna arrangement of any preceding claim.

## Amended claims

### Amended claims in accordance with Rule 137(2) EPC.

1. An antenna arrangement (100, 200) comprising:
a first antenna (101) configured to receive and transmit a first set of near field communication signals;
a second antenna (102) configured to receive and transmit a second set of near field communication signals;
a first transmitter path (103) comprising a first end and a second end, wherein the first antenna (101) is located at the second end of the first transmitter path (103) and wherein the first transmitter path (103) comprises a first matching circuit (113) arranged between the first end of the first transmitter path (103) and the first antenna (101);
a second transmitter path (104) comprising a first end and a second end, wherein the second antenna (102) is located at the second end of the second transmitter path (104) and wherein the second transmitter path (104) comprises a second matching circuit (123) arranged between the first end of the second transmitter path (104) and the second antenna (102);
a first receiver path (130) coupled to the first transmitter path (103) at a first tapping point (132) wherein the first tapping point (132) is arranged between the first end of the first transmitter path (103) and the first antenna (101);
a second receiver path (131) coupled to the second transmitter path (104) at a second tapping point (133) wherein the second tapping point (133) is arranged between the first end of the second transmitter path (104) and the second antenna (102);
a first EMC filter (105) arranged between the first end of the first transmitter path (103) and the first antenna (101); and
a second EMC filter (110) arranged between the first end of the second transmitter path (104) and the second antenna (102), wherein
the first EMC filter (105) comprises a first filter capacitor (107) having a first terminal coupled to the first tapping point (132);
the second EMC filter (110) comprises a second filter capacitor (112) having a first terminal coupled to the output node of the second tapping point (133); and
wherein the antenna arrangement (100, 200) further comprises a reference voltage node (108) coupled between the capacitors of the first filter capacitor (107) and second filter capacitor (112);
**characterized in that** the antenna arrangement (100, 200) further comprises a balun (118, 218) arranged to electrically isolate the first antenna (101) from the second antenna (102), wherein the balun (118, 218) is arranged between the first EMC filter (105) and a first antenna leg (116) wherein the first antenna leg (116) comprises the first matching circuit (113) and the first antenna (101); and wherein the balun (118, 218) is further arranged between the second EMC filter (110) and a second antenna leg (117), wherein the second antenna leg (117) comprises the second matching circuit (123) and the second antenna (102), and wherein the balun (118, 218) comprises: a first winding arranged between the first EMC filter (105) and the first antenna leg (116); and a second winding arranged between the second EMC filter (110) and the second antenna leg (117).

2. The antenna arrangement (100, 200) of claim 1 wherein:
the first antenna (101) comprises a first node coupled to an output node of the first matching circuit (113) and a second node coupled to a reference voltage node (108); and
the second antenna (102) comprises a first node coupled to the second matching circuit (123) and a second node coupled the reference voltage node (108).

3. The antenna arrangement (100, 200) of -claim 1 or 2 wherein:
the first matching circuit (113) comprises:
a first capacitor (114) arranged in series between the balun (118, 218) and the first antenna (101); and
a first grounding capacitor (115) arranged in parallel with the first antenna (101) between the first transmitter path (103) and a reference voltage node (108); and
the second matching circuit (123) comprises:
a second capacitor (124) arranged in series between the balun (118, 218) and the second antenna (102); and
a second grounding capacitor (125) arranged in parallel with the second antenna (102) between the second transmitter path (104) and the reference voltage node (108).

4. An antenna arrangement (300, 400) comprising:
a first antenna (101) configured to receive and transmit a first set of near field communication signals;
a second antenna (102) configured to receive and transmit a second set of near field communication signals;
a first transmitter path (103) comprising a first end and a second end, wherein the first antenna (101) is located at the second end of the first transmitter path (103) and wherein the first transmitter path (103) comprises a first matching circuit (313, 413) arranged between the first end of the first transmitter path (103) and the first antenna (101);
a second transmitter path (104) comprising a first end and a second end, wherein the second antenna (102) is located at the second end of the second transmitter path (104) and wherein the second transmitter path (104) comprises a second matching circuit (323, 423) arranged between the first end of the second transmitter path (104) and the second antenna (102);
a first receiver path coupled to the first transmitter path (103) at a first tapping point wherein the first tapping point is arranged between the first end of the first transmitter path (103) and the first antenna (101);
a second receiver path coupled to the second transmitter path (104) at a second tapping point wherein the second tapping point is arranged between the first end of the second transmitter path (104) and the second antenna (102);
**characterized in that** the antenna arrangement further comprises a balun (118) arranged to electrically isolate the first antenna (101) from the second antenna (102), wherein the balun (118) is arranged between the first matching circuit (313, 413) and the first antenna (101) and wherein the balun (118) is further arranged between the second matching circuit (323, 423) and the second antenna (102), wherein the balun (118) comprises: a first winding arranged between the first matching circuit (313, 413) and the first antenna (101); and a second winding arranged between the second matching circuit (323, 423) and the second antenna (102).

5. The antenna arrangement (300, 400) of claim 4 wherein:
the first matching circuit (313, 413) further comprises a first grounding capacitor (315) arranged between the first transmitter path (103) and a reference voltage node (108); and
the second matching circuit (323, 423) further comprises a second grounding capacitor (325) arranged between the second transmitter path (104) and the reference voltage node (108).

6. The antenna arrangement (300, 400) of claim 4 wherein an intermediate matching capacitor (415) is arranged between the first matching circuit (313, 413) and the second matching circuit (323, 423).

7. The antenna arrangement (100, 200, 300, 400) of any preceding claim further comprising:
a signal sensor configured to measure a signal at the first antenna (101) and provide signalling indicative of the measured signal; and
a controller configured to receive the signalling indicative of the measured signal and determine which antenna has been triggered based on the signalling.

8. The antenna arrangement (100, 200, 300, 400) of any preceding claim wherein the balun (118, 218) is arranged with an additive polarity.

9. The antenna arrangement (100, 200, 300, 400) of any of claims 1 - 7 wherein the balun (118, 218) is arranged with a subtractive polarity.

10. A Near Field Communications, NFC, device (600) comprising the antenna arrangement (100, 200, 300, 400) of any preceding claim.
